# FASCICULE DE BREVET EUROPEEN

(11) **EP 4 430 933 B1**
(45) Date de publication et mention de la délivrance du brevet: **26.03.2025**
(21) Numéro de dépôt: 22797411.0
(22) Date de dépôt: 28.09.2022
(51) Int. Cl.: H10N 30/073, H10N 30/082, H10N 30/086

(54) **PROCEDE DE PREPARATION D'UNE COUCHE MINCE EN MATERIAU FERROELECTRIQUE**
VERFAHREN ZUR HERSTELLUNG EINER DÜNNEN SCHICHT AUS FERROELEKTRISCHEM MATERIAL
METHOD FOR PREPARING A THIN LAYER OF FERROELECTRIC MATERIAL

(30) Priorité: 10.11.2021 FR 2111960
(43) Date de publication de la demande: 18.09.2024
(73) Titulaire: SOITEC, 38190 Bernin (FR)
(72) Inventeur: BELHACHEMI, Djamel, 38190 BERNIN (FR); CAULMILONE, Raphaël, 38190 BERNIN (FR); HUYET, Isabelle, 38190 BERNIN (FR); KONONCHUK, Oleg, 38190 BERNIN (FR)
(74) Mandataire: IP Trust
(86) Numéro de dépôt international: PCT/FR2022/051837
(87) Numéro de publication internationale: WO 2023/084164

(56) Documents cités:
- WO-A1-2020/200986
- KR-A- 20040 077 327
- US-A1- 2017 170 385
- US-A1- 2018 261 756

## Description

### DOMAINE DE L'INVENTION

La présente invention concerne un procédé de préparation d'une couche mince en matériau ferroélectrique. Plus particulièrement, elle concerne un procédé de préparation permettant de préserver le caractère monodomaine du matériau ferroélectrique dans la couche mince du produit final. Ce procédé de préparation est utilisé, par exemple, dans les domaines de la microélectronique, de la micromécanique, de la photonique...

### ARRIERE PLAN TECHNOLOGIQUE DE L'INVENTION

En préambule on rappelle qu'un matériau ferroélectrique est un matériau qui possède une polarisation électrique à l'état naturel, polarisation qui peut être renversée par l'application d'un champ électrique extérieur. On appelle domaine ferroélectrique, chaque région d'un seul tenant du matériau dans lequel la polarisation est uniforme (tous les moments dipolaires sont alignés parallèlement les uns aux autres suivant une direction donnée). Un matériau ferroélectrique peut donc être caractérisé de « monodomaine » dans le cas où ce matériau est constitué d'une seule région dans laquelle la polarisation est uniforme ou de « multidomaine » dans le cas où le matériau ferroélectrique comprend une pluralité de régions présentant des polarités pouvant être différentes.

On connaît de l'état de la technique différents procédés permettant de former une couche mince de matériau ferroélectrique. Il peut s'agir, par exemple, d'une technique d'épitaxie par jet moléculaire (« Molecular Beam Epitaxy » en anglais), de pulvérisation plasma (« Plasma Sputtering » en anglais), dépôt par plasma (« Laser Pulsed Deposition » en anglais), ou encore de l'application de la technologie Smart Cut^{™} selon laquelle une couche mince est prélevée d'un substrat massif en matériau ferroélectrique par fracture au niveau d'une zone fragile (ou plan de fragilisation) formée dans le substrat massif par implantation d'espèces légères.

La présente invention concerne plus particulièrement la préparation d'une couche mince ferroélectrique obtenue par l'application d'un tel procédé, et dont on pourra trouver un exemple particulier de mise en œuvre dans le document EP3646374B1.

Selon ce procédé, et après l'étape de prélèvement de la couche, il est souvent nécessaire de lui appliquer des traitements visant à améliorer son état de surface, sa qualité cristalline ou d'en modifier son épaisseur. La demanderesse a toutefois observé que ces étapes de préparation, lorsqu'elles étaient appliquées à une couche mince ferroélectrique reportée sur un support de silicium, pouvaient conduire à la formation d'une pluralité de domaines ferroélectriques au sein de la couche mince, lui attribuant ainsi un caractère multidomaine.

Une telle caractéristique rend la couche impropre à son utilisation, car elle affecte les performances des dispositifs qui sont appelés à être formés sur/dans la couche mince, comme par exemple des dispositifs acoustiques à ondes de surface (SAW).

Le document WO2020200986 révèle que la formation des domaines ferroélectriques dans une portion superficielle de la couche est provoquée par l'existence de gradients de concentration d'hydrogène dans la couche mince lors de l'application d'un traitement thermique. Cet hydrogène peut notamment correspondre aux espèces légères implantées dans le substrat massif afin d'y former la zone de fragilisation permettant d'y prélever la couche mince. Pour restaurer de manière pérenne le caractère monodomaine de la couche mince, ce document recommande d'amincir la couche mince ferroélectrique après l'application d'un tel traitement thermique.

Cet amincissement peut notamment être réalisé par le polissage mécanochimique de la couche, mais l'enlèvement d'une épaisseur relativement importante de matériaux par polissage tend à détériorer l'uniformité d'épaisseur de cette couche. A titre d'exemple, l'enlèvement d'une épaisseur de l'ordre de 400nm pour viser une épaisseur cible de 700nm environ conduit à former une couche dont l'uniformité d'épaisseur (c'est-à-dire la différence entre l'épaisseur la plus grande et l'épaisseur la plus fine lorsque cette mesure d'épaisseur est réalisée, par exemple par réflectométrie ou ellipsométrie, en de multiples points de mesure sur toute l'étendue de la couche) est de l'ordre de 100nm. Cette variabilité d'épaisseur n'est pas acceptable, car elle ne permet pas de fabriquer collectivement, à partir d'une telle couche, des dispositifs ayant tous les caractéristiques requises.

Des alternatives existent à l'amincissement par polissage mécanochimique. On peut notamment envisager d'amincir la couche mince ferroélectrique par gravure ionique, par exemple par gravure par ions réactifs (ou gravure RIE pour « reactive ion etching » selon l'expression anglo-saxonne usuellement employée). La RIE est un type de gravure sèche qui utilise un plasma d'ions chimiquement réactifs pour enlever le matériau superficiel d'une plaquette. Le plasma est généré sous faible pression par un champ électromagnétique. Les ions à haute énergie du plasma attaquent la surface de la couche et réagissent avec elle pour la pulvériser, et ainsi l'amincir progressivement.

Ainsi, le document US2018261756_propose de former une épaisseur de 2 micromètres (1 micron = 1 micromètre) environ de PZT par dépôt CSD pour constituer une couche piézoélectrique amorphe. Cette couche est exposée en température pour former un poly cristal. Une épaisseur de 50nm est ensuite gravée, par exemple par gravure RIE, afin d'en réduire la rugosité et améliorer sa tension diélectrique. Le document US 2017170385 propose un substrat avec une couche piézoélectrique mince monocristalline , et une étape d'amincissement de la couche mince monocristalline par gravure ionique.

### OBJET DE L'INVENTION

La présente invention vise à déterminer les conditions d'application d'une gravure ionique à la face libre d'une couche mince de matériau ferroélectrique monocristallin en vue de l'amincir. Un but de l'invention est de proposer un procédé de préparation d'une couche mince de matériau ferroélectrique adressant en partie au moins les inconvénients précités. Plus particulièrement, un but de l'invention est de proposer un procédé de gravure ionique d'une couche mince de matériau ferroélectrique monocristallin, obtenue par détachement au niveau d'un plan de fragilisation d'un substrat donneur, ce procédé préservant ou restituant le caractère monodomaine de la couche mince. Un autre but de l'invention est de proposer un procédé d'amincissement d'une couche mince obtenue par détachement au niveau d'un plan de fragilisation d'un substrat donneur, le procédé d'amincissement permettant de former une couche mince de matériau ferroélectrique monocristalline, monodomaine et d'épaisseur plus uniforme que ce qui peut être obtenu par un procédé d'amincissement mettant en œuvre un polissage mécanochimique.

### BREVE DESCRIPTION DE L'INVENTION

En vue de la réalisation de l'un de ces buts, l'objet de l'invention propose un procédé de préparation d'une couche mince en matériau ferroélectrique monocristallin, le procédé comprenant les étapes suivantes :
- une étape de fourniture de la couche mince, la couche mince exposant une première face libre ;
- une étape d'amincissement de la couche mince par gravure ionique et définie par des paramètres de gravure.

Selon l'invention, l'étape de fourniture comprend l'assemblage d'un substrat donneur comprenant un plan de fragilisation avec un substrat support et le détachement de la couche mince au niveau du plan de fragilisation, la couche mince présentant une seconde face opposée à la face libre et disposée sur le substrat support. Par ailleurs, les paramètres de gravure sont choisis pour que la face libre de la couche mince présente une rugosité qui n'excède pas une valeur seuil à l'issue de l'étape d'amincissement.

Selon d'autres caractéristiques avantageuses et non limitatives de l'invention, prises seules ou selon toute combinaison techniquement réalisable :
- l'étape de fourniture comprend la formation du plan de fragilisation par implantation d'ion d'hydrogène dans le substrat donneur ;
- le substrat donneur est un bloc de matériau massif ;
- le substrat donneur comprend une couche épaisse disposée sur un substrat manipulateur ;
- l'étape d'amincissement est suivie d'un polissage mécanochimique au toucher de la face libre ;
- l'étape de fourniture comprend une étape de traitement thermique exposant la face libre de la couche mince à une atmosphère de gazeuse déterminée ;
- l'étape de traitement thermique s'effectue à une température comprise entre 300°C et la température de Curie du matériau ferroélectrique composant la couche mince, et pendant une durée comprise entre 30 minutes et 10 heures ;
- l'étape de traitement thermique s'effectue sous une atmosphère gazeuse oxydante ou neutre ;
- le procédé comprend, entre l'étape de traitement thermique et l'étape d'amincissement, une étape de lissage de la face libre pour réduire sa rugosité de surface à une valeur inférieure à la valeur seuil de rugosité ;
- l'étape de lissage comprend un polissage mécanochimique au toucher de la face libre ;
- la valeur seuil de rugosité est comprise entre 3 nm et 7 nm.

Selon un autre aspect, l'invention concerne un substrat comprenant une couche mince en matériau ferroélectrique monocristallin et monodomaine disposé sur un support, la couche mince présentant une épaisseur inférieure ou égale à 700 nm et une uniformité d'épaisseur inférieure ou égale à 60 nm.

Selon d'autres caractéristiques avantageuses et non limitatives de l'invention, prises seules ou selon toute combinaison techniquement réalisable :
- le substrat te comprend une couche intercalaire amorphe disposée entre la couche mince et le support ;
- la couche intercalaire amorphe est un oxyde de silicium, un oxynitrure de silicium ou un nitrure de silicium ;
- la couche mince comprend une face libre présentant une rugosité inférieure à 0,5 nm ;
- le matériau ferroélectrique de la couche mince est LiTaO3 ou du LiNbO3 ;
- le matériau ferroélectrique de la couche mince présente une direction cristalline 42°RY ;
- le support comprend, du côté de la couche mince, une couche de piégeage de charges.

### BREVE DESCRIPTION DES DESSINS

D'autres caractéristiques et avantages de l'invention ressortiront de la description détaillée de l'invention qui va suivre en référence aux figures annexées sur lesquelles :
[Fig. 1]

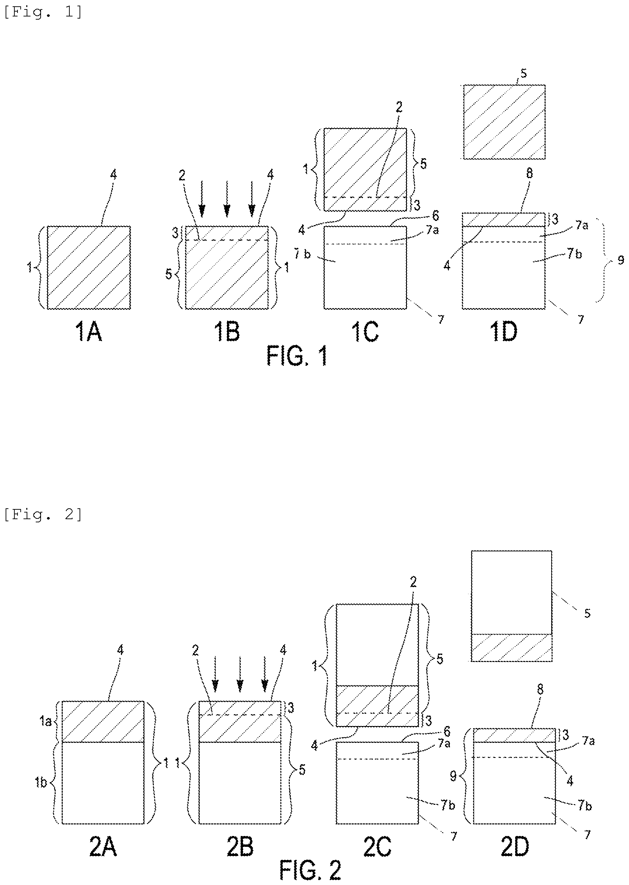

   La figure 1 représente une étape de fourniture d'une couche mince selon un premier mode de mis en œuvre ;
[Fig. 2]
   La figure 2 représente une étape de fourniture d'une couche mince selon un second mode de mis en œuvre ;
[Fig. 3]

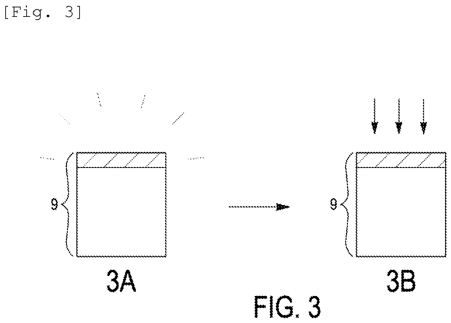

   La figure 3 représente un procédé de préparation conforme à l'invention.

### DESCRIPTION DETAILLEE DE L'INVENTION

Par souci de simplification de la description à venir, les mêmes références sont utilisées pour des éléments identiques ou assurant la même fonction dans l'état de la technique ou dans les différents modes de mise en œuvre exposés du procédé

Les figures sont des représentations schématiques qui, dans un objectif de lisibilité, ne sont pas à l'échelle. En particulier, les épaisseurs des couches ne sont pas à l'échelle par rapport aux dimensions latérales de ces couches.

L'expression « coefficient de dilatation thermique » employée dans la suite de cette description en relation à une couche ou à un substrat fait référence au coefficient de dilatation selon une direction définie dans le plan principal définissant cette couche ou ce substrat. Si le matériau est anisotrope, la valeur du coefficient retenue sera celle de plus grande amplitude. La valeur du coefficient est celle mesurée à température ambiante.

L'invention concerne un procédé de préparation d'une couche mince 3 en un matériau ferroélectrique transférée d'un substrat donneur 1 monocristallin sur un substrat support 7 par une technique de transfert incluant une implantation d'espèces légères dans le substrat donneur 1. Plusieurs modes de réalisation de cette étape de fourniture d'une couche mince existent.

Suivant un premier mode de réalisation, représenté sur les figures 1A à 1D, le substrat donneur 1 est composé d'un bloc massif, monocristallin et monodomaine de matériau ferroélectrique, par exemple de LiTaO3, LiNbO3, LiAlO3, BaTiO3, PbZrTiO3, KNbO3, BaZrO3, CaTiO3, PbTiO3 ou de KTaO3. Le substrat donneur 1 peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur peut avoir été prélevé d'un lingot de matériaux ferroélectrique, ce prélèvement ayant été réalisé de manière à ce que le substrat donneur 1 présente une orientation cristalline prédéterminée. L'orientation est choisie en fonction de l'application visée. Ainsi, il est usuel de choisir une orientation 42°RY dans le cas où l'on souhaite exploiter les propriétés de la couche mince pour former un filtre SAW. Mais l'invention n'est nullement limitée à une orientation cristalline particulière.

Quel que soit l'orientation cristalline du substrat donneur 1, le procédé comprend l'introduction dans le substrat donneur 1 d'au moins une espèce légère. Cette introduction peut correspondre à une implantation, c'est-à-dire, un bombardement ionique d'une face plane 4 du substrat donneur 1 par des espèces légères telles que des ions d'hydrogène et/ou d'hélium.

De façon connue en soi, et comme cela est représenté sur la figure 1B, les ions implantés ont pour but de former un plan de fragilisation 2 délimitant une couche mince 3 de matériau ferroélectrique à transférer qui est située du côté de la face plane 4 et une autre partie 5 formant le reste du substrat.

La nature, la dose des espèces implantées et l'énergie d'implantation sont choisies en fonction de l'épaisseur de la couche que l'on souhaite transférer et des propriétés physico-chimiques du substrat donneur. Dans le cas d'un substrat donneur 1 en LiTaO3, on pourra ainsi choisir d'implanter une dose d'hydrogène comprise entre 1^{E}16 et 5^{E}17 at/cm² avec une énergie comprise entre 30 et 300keV pour délimiter une couche mince 3 de l'ordre de 200 à 2000 nm.

Dans une étape suivante, représentée sur la figure 1C, on assemble la face plane 4 du substrat donneur 1 avec une face 6 d'un substrat support 7. Le substrat support 7 peut présenter la même dimension et la même forme que celles du substrat donneur. Pour des raisons de disponibilité et de coût, le substrat support 7 est une plaquette de silicium, monocristallin ou polycristallin. Mais plus généralement, le substrat support 7 peut être constitué de tout matériau, par exemple du silicium, du saphir ou du verre, et présenter toute forme.

Dans un mode de mis en œuvre particulier, le substrat support comprend un substrat de base 7b, par exemple en silicium monocristallin, sur lequel est disposé une couche de piégeage de charges 7a. Le substrat de base 7b peut présenter une résistivité élevée, supérieure à 1000 ohms.cm ou plus conventionnelle, inférieure à 1000 ohms.cm. La couche de piégeage de charges 7a, comme cela est bien connu en soi, peut être formée d'une couche en silicium polycristallin, et présenter une épaisseur typiquement comprise entre 500nm et 10 µm.

Préalablement à l'étape d'assemblage, il peut être envisagé de préparer les faces des substrats à assembler par une étape de nettoyage, brossage, séchage, polissage, ou une activation par exemple par plasma.

L'étape d'assemblage peut correspondre à la mise en contact intime du substrat donneur 1 avec le substrat support 7 par adhésion moléculaire et/ou collage électrostatique. Optionnellement, pour faciliter l'assemblage des deux substrats 1, 7 notamment lorsqu'ils sont assemblés par collage direct, au moins une couche intercalaire amorphe peut être formée préalablement à l'assemblage, soit sur la face plane 4 du substrat donneur 1, soit sur la face plane 6 à assembler du substrat support 7, soit sur les deux. Cette couche intercalaire est par exemple constituée d'oxyde de silicium, de nitrure de silicium, d'oxynitrure de silicium.

Elle peut présenter une épaisseur comprise entre quelques nanomètres et quelques µm.

On privilégiera une couche intercalaire présentant une faible concentration en hydrogène ou faisant barrière à la diffusion d'hydrogène pour suivre les enseignements du document WO2020200986 et éviter ainsi la formation d'une zone multidomaine à l'interface entre la couche mince et la couche intercalaire amorphe, du côté de la seconde face de la couche mince 3. La couche intercalaire peut être élaborée selon les différentes techniques connues de l'état de l'art, tels des traitements thermiques d'oxydation ou de nitruration, des dépôts chimiques (PECVD, LPCVD...), etc.

A l'issue de cette étape d'assemblage, on dispose d'un ensemble comprenant les deux substrats associés, la face plane 6 du substrat support 7 adhérant à la face plane 4 du substrat donneur 1.

L'ensemble est alors traité pour détacher la couche mince 3 de matériau ferroélectrique du substrat donneur 1, par exemple par clivage au niveau du plan de fragilisation 2.

Cette étape de détachement peut ainsi comprendre l'application à l'ensemble d'un traitement thermique dans une gamme de température de l'ordre de 80°C à 300° pour permettre le transfert de la couche mince 3 sur le substrat support 7. En remplacement ou en complément du traitement thermique, cette étape peut comprendre l'application d'une lame ou un jet de fluide gazeux ou liquide au niveau du plan de fragilisation 2.

A la suite de cette étape de détachement, on obtient la structure 9 représentée à la figure 1D. Cette structure 9 comprend la couche mince 3 de matériau ferroélectrique monocristallin comprenant une première face libre 8 et une deuxième face 4 disposée sur le substrat support 7.

Les figures 2A à 2D représentent un deuxième mode de réalisation, particulièrement adapté à la réalisation d'une structure 9 hétérogène, dans laquelle la couche mince 3 présente un coefficient de dilatation thermique bien différent de celui du support 7, par exemple présentant une différence de plus de 10%. Ce deuxième mode de mise en œuvre diffère principalement du premier mode de mise en œuvre par la nature du substrat donneur 1. Par souci de concision, on ne présente donc ici que les éléments de ce deuxième mode de mis en œuvre se différenciant du premier, toutes les autres caractéristiques du premier mode de réalisation pouvant donc être prévues.

En référence à la figure 2A, le substrat donneur 1 est dans ce cas composé d'une couche épaisse de matériau ferroélectrique 1a, possédant les mêmes propriétés que celles décrites pour le bloc massif de matériaux ferroélectrique en relation avec le premier mode de réalisation, et d'un substrat manipulateur 1b.

Le substrat manipulateur 1b est avantageusement constitué d'un matériau (ou d'une pluralité de matériaux) lui conférant un coefficient de dilatation thermique proche de celui composant le substrat support 7. Par « proche », on signifie que la différence de coefficient de dilatation thermique du substrat manipulateur 1b et de celui du support est moindre, en valeur absolue, que la différence de dilatation thermique du bloc massif du matériau ferroélectrique et de celui du substrat support 7.

Préférentiellement, le substrat manipulateur 1b et le substrat support présentent un coefficient de dilatation thermique identique. Lors de l'assemblage du substrat donneur 1 et du support 7, on forme un ensemble apte à supporter un traitement thermique à une température relativement élevée. Pour des raisons de simplicité de mise en œuvre, cela peut être obtenu en choisissant le substrat manipulateur 1b pour qu'il soit constitué du même matériau que celui du substrat support 7.

Pour former le substrat donneur 1 de ce mode de réalisation, on assemble préalablement un bloc massif de matériau ferroélectrique avec le substrat manipulateur 1a, par exemple selon une technique de collage par adhésion moléculaire telle que cela a été décrit préalablement ou à l'aide d'une couche adhésive. Puis, on forme la couche de matériau ferroélectrique 1a par amincissement, par exemple par meulage et/ou polissage mécanochimique et/ou gravure. Avant l'assemblage on peut avoir prévu la formation d'une couche d'adhésion (par exemple par dépôt d'oxyde de silicium et/ou de nitrure de silicium, d'une couche adhésive par exemple un polymère) sur l'une et/ou l'autre des faces mises en contact. L'assemblage peut comprendre l'application d'un traitement thermique de faible température (compris par exemple entre 50 et 300°C, typiquement 100°C) permettant de renforcer suffisamment l'énergie de collage pour permettre l'étape suivante d'amincissement.

Le substrat manipulateur 1b est choisi pour présenter une épaisseur sensiblement équivalente à celle du substrat support 7. L'étape d'amincissement est conduite de telle sorte que la couche épaisse 1a présente une épaisseur suffisamment faible pour que les contraintes générées lors des traitements thermiques appliqués dans la suite du procédé soient d'intensité réduite. Dans le même temps, cette épaisseur est suffisamment importante pour pouvoir y prélever la couche mince 3, ou une pluralité de telles couches. Cette épaisseur peut par exemple être comprise entre 5 et 400 µm.

Les étapes suivantes du procédé de ce second mode de mise en œuvre sont équivalentes à celles des étapes décrites dans le premier mode de réalisation. On procède à l'implantation d'espèces légères au sein de la couche épaisse 1a pour générer un plan de fragilisation 2 qui marque la séparation de la couche mince 3 du reste 5 du substrat donneur 1, comme cela est représenté sur la figure 2B. Cette étape est suivie de l'étape d'assemblage du substrat donneur 1 sur le substrat support 7, tel que cela est représenté sur la figure 2C. On détache ensuite la couche mince 3 du reste du substrat 5 pour obtenir la structure 9 représentée sur la figure 2D.

Ce mode de réalisation est avantageux en ce que l'assemblage formé du substrat donneur 1 et du support 7 peut être exposé à une température bien plus élevée que celle appliquée dans le cadre du premier mode de réalisation, sans risque de fracture incontrôlée de l'un des substrats ou de délamination du substrat donneur 1 de la couche mince 3. La structure équilibrée, en termes de coefficient de dilatation thermique de cet assemblage, permet ainsi de faciliter l'étape de détachement de la couche mince 3 en exposant l'assemblage à une température relativement élevée, par exemple comprise entre 100 et 500 °C.

Quel que soit le mode de mise en œuvre choisi, et comme cela a été précisé en introduction de cette demande, des étapes de finition de la couche mince 3 sont ensuite nécessaires pour améliorer sa qualité cristalline et de surface, et fournir une couche mince 3 dont l'épaisseur correspond à, ou s'approche de, une épaisseur cible. Ces étapes de finition visent notamment à éliminer une couche superficielle écrouie et rugueuse, résultant du clivage et du détachement de la couche mince 3 du reste du substrat donneur.

Comme cela est exposé dans le document WO2020200986, on applique tout d'abord une étape de traitement thermique à la couche mince 3 transférée. Ce traitement thermique permet de guérir des défauts cristallins présents dans la couche mince 3, voire même à réduire la rugosité de la face libre de la couche mince. En outre, il contribue à consolider le collage entre la couche mince 3 et le support 7. Le traitement thermique porte la structure à une température comprise entre 300°C et la température de Curie du matériau ferroélectrique pendant une durée comprise entre 30 minutes et 10h heures. Ce traitement thermique est préférentiellement réalisé en exposant la face libre de la couche mince 3 à une atmosphère gazeuse oxydante ou neutre, c'est-à-dire sans recouvrir cette face de la couche mince d'une couche de protection. Pour éviter toute ambiguïté, on souligne que l'étape de traitement thermique de finition de la couche mince 3 est bien distincte du traitement thermique de fracture appliquée à la structure assemblée.

Un procédé conforme à l'invention comporte également, après le traitement thermique de finition, une étape d'amincissement de la couche mince 3. Cette étape vise notamment à éliminer la couche superficielle multidomaine qui peut avoir été créée au cours de l'étape précédente de traitement thermique. Elle vise également à fournir une couche mince 3 dont l'épaisseur correspond à une épaisseur cible, comme cela a été évoqué précédemment. Cet amincissement peut, d'une manière générale, correspondre au polissage de la première face libre 8 de la couche mince 3, par exemple par des techniques d'amincissement mécanique, mécanochimique. Cet amincissement peut conduire à enlever une épaisseur comprise entre 100nm et 1 µm, selon l'épaisseur de la couche transférée, l'épaisseur cible de la couche mince 3, l'épaisseur de la couche multidomaine et/ou écrouie présente superficiellement à l'issue du traitement thermique de finition. Mais, comme cela a été présenté en introduction de cette demande, une telle approche d'amincissement par polissage mécanochimique tend à dégrader la caractéristique d'uniformité de la couche mince 3, ce qui n'est pas acceptable. Des expériences complémentaires menées par la Demanderesse ont ainsi montré que cette uniformité se dégradait d'environ 25 nm pour un enlèvement de 100nm.

Dans la recherche d'une solution alternative à un amincissement par polissage, la demanderesse a réalisé les expérimentations suivantes visant à mettre en œuvre cette étape d'amincissement par gravure ionique.

Un véhicule d'expérimentation consistait en une couche mince monocristalline de tantalate de lithium reporté sur un substrat de silicium (conformément au procédé qui vient d'être exposé et incluant le traitement thermique de finition), la couche mince n'ayant toutefois pas subi d'étape d'amincissement. Le procédé de préparation appliquée à cette couche mince consistait donc seulement en l'étape de traitement thermique. La couche mince présentait donc une épaisseur superficielle multidomaine. Elle présentait une épaisseur de 680nm et une rugosité de l'ordre de 10nm RMS.

Sur ce véhicule on a appliqué respectivement un premier procédé de gravure ionique de type RIE P1 et un second procédé de gravure ionique de type RIE P2, chacun à base de gaz réactif de CHF3. Comme cela a été rappelé en introduction de cette demande, un procédé de gravure RIE consiste à exposer la surface à traiter (ici la face libre 8 de la couche mince 3) à un plasma d'ion réactif. Ce plasma conduit à graver superficiellement le matériau constituant la face libre de la couche mince.

L'effet d'une gravure ionique, notamment de type RIE, sur la rugosité de la couche, est dépendant des paramètres de gravure, et notamment de la puissance du champ radio fréquence formée pour créer le plasma d'ions réactifs, du débit du gaz réactif, de la température de la couche mince (qui peut être maitrisée en pilotant la température du support sur lequel repose le substrat), et de la pression régnant dans la chambre de traitement de l'équipement RIE.

Le premier procédé RIE P1 appliqué au véhicule présentait des paramètres de gravure tendant à augmenter la rugosité de la couche mince, notamment en choisissant un débit de gaz réactif introduit dans la chambre de 65 sccm (pour «Standard Cubic Centimeter per Minute » ou « centimètre cube par minute dans des conditions standards »), soit 1,08 10^-6 m^3/s pour des conditions standards. Le procédé a été appliqué sur le véhicule pour réduire l'épaisseur de la couche mince de 200nm et donc aboutir à une épaisseur de 480nm.

Le second procédé RIE P2 appliqué au véhicule présentait des paramètres de gravure tendant à réduire la rugosité de la couche mince, notamment en choisissant un débit de gaz réactif introduit dans la chambre de 20 sccm, soit 0,3 10^-6 m^3/s dans des conditions standards. Le procédé a été appliqué au véhicule pour réduire l'épaisseur de la couche mince de 200nm et donc aboutir à une épaisseur de 480nm.

Le tableau suivant présente les résultats obtenus à l'issue des expériences menées. Les rugosités sont exprimées en grandeurs RMS mesurées sur un champ de 5x5 µm par mesure par force atomique.

| | Caractéristique de la couche mince après l'étape d'amincissement |
|---|---|
| P1 | Multidomaine |
| | Rugosité : 17 nm |
| | Uniformité :15,3 nm |
| P2 | Monodomaine |
| | Rugosité : 2,9nm |
| | Uniformité : 9,9nm |

On note que l'application du premier procédé P1 (dont les paramètres de gravure tendent à augmenter la rugosité de la couche mince) conduit à obtenir une couche amincie dont la rugosité est importante. De plus, et contrairement à ce qui était attendu, le caractère monodomaine de cette couche mince 3 n'a pas été restauré.

Au contraire, l'application du second procédé P2 (dont les paramètres de gravure tendent à réduire la rugosité de la couche mince) conduit non seulement à fournir une couche amincie dont la rugosité est bien moindre, mais qui en plus permet de restaurer le caractère monodomaine de la couche mince 3.

On note dans les deux cas que le véhicule n'ayant pas subi de traitement d'amincissement par polissage, son uniformité est de bonne qualité.

Selon une interprétation possible de ces résultats, qui ne limitent en rien les performances du procédé de préparation de l'invention, il semblerait que les ions du plasma interagissent avec la matière piézoélectrique présente dans les pics de rugosité lorsque celle-ci est excessive, pour en modifier les propriétés de polarisation ce qui conduit à créer ou maintenir superficiellement une épaisseur multidomaine.

Pour se prémunir de ce phénomène, il apparaît donc nécessaire de choisir les paramètres de gravure pour réduire la rugosité de la couche mince sous une valeur seuil à partir de laquelle cette modification des propriétés de polarisation se déclenche.

Plus la rugosité initiale de la couche mince, c'est-à-dire la rugosité de la couche mince juste avant l'application de l'étape d'amincissement, est importante et notamment lorsqu'elle excède la valeur seuil de rugosité, plus les paramètres de gravure doivent être maitrisés pour réduire et/ou ne pas excéder la valeur seuil de rugosité au cours et à l'issue de cette étape. A l'inverse, plus la rugosité initiale est faible, et notamment lorsqu'elle est inférieure à la valeur seuil de rugosité et plus les paramètres de gravure peuvent être choisis librement, sans toutefois conduire à excéder la valeur seuil de rugosité à l'issue de l'étape d'amincissement. De la sorte le procédé est apte à fournir une couche mince monodomaine et dont l'uniformité est bien meilleure que celle d'une couche amincie par polissage mécanochimique.

Selon la nature du matériau ferroélectrique constituant la couche mince, la valeur seuil de rugosité peut être comprise entre 3nm et 7nm, par exemple 5 nm ou 6 nm.

L'invention met donc à profit ces résultats pour proposer un procédé de préparation de la couche mince 3, représenté schématiquement sur la figure 3.

Le procédé de préparation comporte donc une étape de fourniture de la couche mince 3 monocristalline conduisant à exposer la première face libre 8 de cette couche, comme cela a été exposé précédemment, par exemple selon l'un ou l'autres des procédés représentés sur les figures 1 et 2. Cette étape de fourniture comprend également l'application de l'étape de traitement thermique de finition visant notamment à évacuer l'hydrogène présente de la couche mince et conduisant à former une épaisseur superficielle multidomaine (Figure 3A). A l'issue de cette étape, la couche mince présente une rugosité déterminée, typiquement de l'ordre de 10 nm RMS mesuré sur un champ de 5x5 µm par mesure par force atomique (AFM). Elle présente une épaisseur relativement épaisse de l'ordre de 1000nm ou plus.

Après cette étape de fourniture, un procédé de préparation conforme à l'invention comprend une étape d'amincissement visant à fournir une couche d'épaisseur choisie, typiquement de l'ordre de 700nm ou moins, monocristalline et monodomaine. D'une manière très générale, et comme cela est représenté sur la figure 3B, cette étape d'amincissement est réalisée par gravure ionique, c'est-à-dire exposant la face libre 8 de la couche mince à des ions, avantageusement des ions réactifs. Il peut notamment s'agir d'ions d'argon, de CHF3, ou tous autres ions susceptibles de réagir chimiquement avec le matériau composant la couche mince piézoélectrique. Selon l'épaisseur de la couche mince 3 fournie et l'épaisseur cible, l'étape d'amincissement peut conduire à éliminer une épaisseur de l'ordre de 50nm à 900nm, et typiquement éliminer une épaisseur supérieure à 100nm, par exemple comprise entre 100nm et 400nm. Dans tous les cas, l'uniformité de la couche est bien moins dégradée que lorsque la couche est amincie par polissage mécanochimique, cette uniformité d'épaisseur peut être inférieure à 60nm tel que cela est mesuré par réflectométrie ou ellipsométrie voire inférieure à 30nm et même atteindre 20nm ou moins.

Pour atteindre cela, et selon l'invention, les paramètres de gravure sont choisis pour que la face libre 8 de la couche mince 3 présente une rugosité qui n'excède pas une valeur seuil à l'issue de l'étape d'amincissement. On note qu'au regarde l'épaisseur relativement importante à éliminer, il aurait été plus naturelle de choisir les paramètres de gravure pour que ceux-ci favorisent la vitesse d'enlèvement plutôt que la rugosité.

Comme cela a été précisé précédemment, l'effet « rugosifiant » de l'étape d'amincissement par gravure ionique peut être réduit en réduisant l'un au moins des paramètres de gravure suivants : le flux de gaz réactifs, la puissance du champ radio fréquence formé pour créer le plasma d'ions réactifs, la température de la couche mince 3, et de la pression régnant dans la chambre de traitement de l'équipement de gravure.

La personne du métier pourra très simplement ajuster ces paramètres au cours d'une série d'expériences de routine pour déterminer, pour un matériau donné et pour un état de surface initial de la couche mince 3, quelle combinaison de paramètres conduit à graver tout en évitant d'excéder la valeur seuil de rugosité.

Si l'étape de fourniture n'est pas suffisamment maitrisée et que cette rugosité varie de la fourniture d'une couche mince à une autre, le procédé de préparation peut prévoir entre l'étape de fourniture et l'étape d'amincissement, une étape de mesure de la rugosité de la couche mince afin d'ajuster, couche à couche, les paramètres de gravure du procédé de gravure RIE à la rugosité mesurée.

Selon un mode de mis en œuvre particulièrement intéressant, le procédé de préparation de l'invention comprend, entre l'étape de traitement thermique de finition et l'étape d'amincissement, une étape de lissage de la face libre 8 pour réduire sa rugosité de surface à une valeur initiale relativement faible, par exemple inférieure à 1 nm RMS.

Par exemple, l'étape de lissage comprend un polissage mécanochimique « au toucher » (de l'expression anglo-saxonne « touch polish ») de la face libre 8. Ce polissage vise à réduire la rugosité de la couche mince, sans amincissement sensible de cette couche. Cette étape de lissage très superficielle n'affecte pas l'uniformité de la couche.

La rugosité de la face libre 8 de la couche mince 3 étant réduite, les paramètres de gravure peuvent être choisis plus librement qu'en l'absence de cette étape de lissage, en réduisant le risque d'excéder la valeur seuil de rugosité à l'issue de l'étape d'amincissement, et donc en restaurant le caractère monodomaine de la couche mince.

Que cette étape de lissage préliminaire soit mise en œuvre ou pas, le procédé de préparation de la couche mince peut être suivi, après l'étape d'amincissement, d'un polissage mécanochimique au toucher de la face libre. Cette étape permet de préparer la face libre 8 pour qu'elle présente (si cela n'a pas été obtenu à l'issue de l'étape d'amincissement) au final une rugosité faible, par exemple inférieure à 0,5nm RMS 5x5 µm par mesure par force atomique (AFM) sans affecter l'uniformité de cette couche.

Bien entendu l'invention n'est pas limitée aux modes de mise en œuvre décrits et on peut y apporter des variantes de réalisation sans sortir du cadre de l'invention tel que défini par les revendications indépendantes.

## Revendications

1. Procédé de préparation d'une couche mince (3) en matériau ferroélectrique monocristallin, le procédé comprenant les étapes suivantes :
- une étape de fourniture de la couche mince (3), la couche mince (3) exposant une première face libre (8);
- une étape d'amincissement de la couche mince par gravure ionique et définie par des paramètres de gravure ;
le procédé étant **caractérisé en ce que** l'étape de fourniture comprend l'assemblage d'un substrat donneur (1) comprenant un plan de fragilisation (2) avec un substrat support (7) et le détachement de la couche mince (3) au niveau du plan de fragilisation (2), la couche mince (3) présentant une seconde face opposée à la face libre (8) et disposée sur le substrat support (7), et **en ce que** les paramètres de gravure sont choisis pour que la face libre (8) de la couche mince (3) présente une rugosité qui n'excède pas une valeur seuil à l'issue de l'étape d'amincissement.

2. Procédé selon la revendication précédente dans lequel l'étape de fourniture comprend la formation du plan de fragilisation (2) par implantation d'ion d'hydrogène dans le substrat donneur (1).

3. Procédé selon l'une des revendications précédentes dans lequel l'étape d'amincissement est suivie d'un polissage mécanochimique au toucher de la face libre (8).

4. Procédé selon l'une des revendications précédentes dans lequel l'étape de fourniture comprend une étape de traitement thermique exposant la face libre (8) de la couche mince (3) à une atmosphère gazeuse déterminée.

5. Procédé selon la revendication précédente, dans lequel l'étape de traitement thermique s'effectue à une température comprise entre 300°C et la température de Curie du matériau ferroélectrique composant la couche mince (3), et pendant une durée comprise entre 30 minutes et 10 heures.

6. Procédé selon la revendication 4 ou 5 dans lequel l'étape de traitement thermique s'effectue sous une atmosphère gazeuse oxydante ou neutre.

7. Procédé selon l'une des revendications 4 à 6 comprenant, entre l'étape de traitement thermique et l'étape d'amincissement, une étape de lissage de la face libre (8) pour réduire sa rugosité de surface à une valeur inférieure à la valeur seuil de rugosité.

8. Procédé selon la revendication précédente dans lequel l'étape de lissage comprend un polissage mécanochimique au toucher de la face libre (8).

9. Procédé selon l'une des revendications précédentes dans lequel la valeur seuil de rugosité est comprise entre 3 nm et 7 nm.

10. Substrat comprenant une couche mince (3) en matériau ferroélectrique monocristallin et monodomaine disposée sur un support (7), la couche mince présentant une épaisseur inférieure ou égale à 700 nm et une uniformité d'épaisseur inférieure ou égale à 60 nm.

11. Substrat selon la revendication précédente comprenant une couche intercalaire amorphe disposée entre la couche mince (3) et le support (7).

12. Substrat selon la revendication précédente dans lequel la couche intercalaire amorphe est un oxyde de silicium, un oxynitrure de silicium ou un nitrure de silicium.

13. Substrat selon l'une des revendications 10 à 12 dans lequel la couche mince (3) comprend une face libre (8) présentant une rugosité inférieure à 0,5 nm.

14. Substrat selon l'une des revendications 10 à 13 dans lequel le matériau ferroélectrique de la couche mince (3) est du LiTaO₃ ou du LiNbO₃.

15. Substrat selon l'une des revendications 10 à 14 dans lequel le support (7) comprend, du côté de la couche mince (3), une couche de piégeage de charges.

## Patentansprüche

1. Verfahren zum Herstellen einer Dünnschicht (3) aus ferroelektrischem monokristallinem Material, das Verfahren umfassend die folgenden Schritte:
- einen Schritt zum Bereitstellen der Dünnschicht (3), wobei die Dünnschicht (3) eine erste freie Fläche (8) freilegt;
- einen Schritt zum Ausdünnen der Dünnschicht durch Ionenätzen und definiert durch Ätzparameter;
wobei das Verfahren **dadurch gekennzeichnet ist, dass** der Bereitstellungsschritt das Zusammenfügen eines Donorsubstrats (1), umfassend eine Versprödungsebene (2), mit einem Trägersubstrat (7) und das Ablösen der Dünnschicht (3) an der Versprödungsebene (2) umfasst, wobei die Dünnschicht (3) eine zweite Fläche aufweist, die der freien Fläche (8) gegenüberliegt und auf dem Trägersubstrat (7) angeordnet ist, **und dass** die Ätzparameter so gewählt sind, dass die freie Fläche (8) der Dünnschicht (3) eine Rauheit aufweist, die an dem Ende des Ausdünnungsschrittes einen Schwellenwert nicht überschreitet.

2. Verfahren nach dem vorstehenden Anspruch, wobei der Bereitstellungsschritt die Ausbildung der Versprödungsebene (2) durch Wasserstoffionenimplantation in das Donorsubstrat (1) umfasst.

3. Verfahren nach einem der vorstehenden Ansprüche, wobei auf den Ausdünnungsschritt ein mechanisch-chemisches Berührungspolieren der freien Fläche (8) folgt.

4. Verfahren nach einem der vorstehenden Ansprüche, wobei der Bereitstellungsschritt einen Wärmebehandlungsschritt umfasst, wobei die freie Fläche (8) der Dünnschicht (3) für eine spezifische Gasatmosphäre freigelegt wird.

5. Verfahren nach dem vorstehenden Anspruch, wobei der Wärmebehandlungsschritt bei einer Temperatur zwischen 300 °C und der Curie-Temperatur des ferroelektrischen Materials, aus dem die Dünnschicht (3) besteht, und für einen Zeitraum zwischen 30 Minuten und 10 Stunden erfolgt.

6. Verfahren nach Anspruch 4 oder 5, wobei der Wärmebehandlungsschritt in einer oxidierenden oder neutralen Gasatmosphäre erfolgt.

7. Verfahren nach einem der Ansprüche 4 bis 6, umfassend zwischen dem Wärmebehandlungsschritt und dem Ausdünnungsschritt einen Schritt zum Glätten der freien Fläche (8) zum Reduzieren ihrer Oberflächenrauheit auf einen Wert, der unter dem Rauheitsschwellenwert liegt.

8. Verfahren nach dem vorstehenden Anspruch, wobei der Glättungsschritt ein chemisch-mechanisches Berührungspolieren der freien Fläche (8) umfasst.

9. Verfahren nach einem der vorstehenden Ansprüche, wobei der Rauheitsschwellenwert zwischen 3 nm und 7 nm liegt.

10. Substrat, umfassend eine Dünnschicht (3) aus monokristallinem und monodomänem ferroelektrischem Material, die auf einem Träger (7) angeordnet ist, wobei die Dünnschicht eine Dicke von weniger als oder gleich 700 nm und eine Dickengleichmäßigkeit von weniger als oder gleich 60 nm aufweist.

11. Substrat nach dem vorstehenden Anspruch, umfassend eine amorphe Zwischenschicht, die zwischen der Dünnschicht (3) und dem Träger (7) angeordnet ist.

12. Substrat nach dem vorstehenden Anspruch, wobei die amorphe Zwischenschicht ein Siliziumoxid, ein Siliziumoxynitrid oder ein Siliziumnitrid ist.

13. Substrat nach einem der Ansprüche 10 bis 12, wobei die Dünnschicht (3) eine freie Fläche (8) umfasst, die eine Rauheit von weniger als 0,5 nm aufweist.

14. Substrat nach einem der Ansprüche 10 bis 13, wobei das ferroelektrische Material der Dünnschicht (3) LiTaO₃ oder LiNbO₃ ist.

15. Substrat nach einem der Ansprüche 10 bis 14, wobei der Träger (7) auf der Seite der Dünnschicht (3) eine Ladungseinfangschicht aufweist.

## Claims

1. A method for preparing a thin film (3) of monocrystalline ferroelectric material, the method comprising the following steps:
- a step of providing the thin film (3), the thin film (3) exposing a first free face (8);
- a step of thinning the thin film by ion etching and defined by etching parameters;
the method being **characterized in that** the providing step comprises assembling a donor substrate (1) comprising an embrittlement plane (2) with a support substrate (7) and detaching the thin film (3) at the embrittlement plane (2), the thin film (3) having a second face opposite the free face (8) and arranged on the support substrate (7), **and in that** the etching parameters are chosen so that the free face (8) of the thin film (3) has a roughness that does not exceed a threshold value at the end of the thinning step.

2. The method according to the preceding claim, wherein the providing step comprises the formation of the embrittlement plane (2) by implantation of hydrogen ions in the donor substrate (1).

3. The method according to either of the preceding claims, wherein the thinning step is followed by chemical-mechanical touch-polishing of the free face (8).

4. The method according to any of the preceding claims, wherein the providing step comprises a thermal treatment step exposing the free face (8) of the thin film (3) to a certain gaseous atmosphere.

5. The method according to the preceding claim, wherein the thermal treatment step is carried out at a temperature between 300°C and the Curie temperature of the ferroelectric material making up the thin film (3), and for a period of between 30 minutes and 10 hours.

6. The method according to claim 4 or 5, wherein the thermal treatment step is carried out under an oxidizing or neutral gaseous atmosphere.

7. The method according to any of claims 4 to 6, comprising, between the thermal treatment step and the thinning step, a step of smoothing the free face (8) to reduce its surface roughness to a value lower than the roughness threshold value.

8. The method according to the preceding claim, wherein the smoothing step comprises chemical-mechanical touch-polishing of the free face (8).

9. The method according to any of the preceding claims, wherein the roughness threshold value is between 3 nm and 7 nm.

10. A substrate comprising a thin film (3) of monocrystalline and monodomain ferroelectric material arranged on a support (7), the thin film having a thickness less than or equal to 700 nm and a thickness uniformity less than or equal to 60 nm.

11. The substrate according to the preceding claim comprising an amorphous interlayer placed between the thin film (3) and the support (7).

12. The substrate according to the preceding claim, wherein the amorphous interlayer is a silicon oxide, a silicon oxynitride or a silicon nitride.

13. The substrate according to any of claims 10 to 12, wherein the thin film (3) comprises a free face (8) having a roughness of less than 0.5 nm.

14. The substrate according to any of claims 10 to 13, wherein the ferroelectric material of the thin film (3) is LiTaO₃ or LiNbO₃.

15. The substrate according to any of claims 10 to 14, wherein the support (7) comprises, on the side of the thin film (3), a charge trapping layer.
